# EUROPÄISCHE PATENTANMELDUNG

(11) **EP 3 562 286 A1**
(43) Veröffentlichungstag der Anmeldung: **30.10.2019**
(21) Anmeldenummer: 18169246.8
(22) Anmeldetag: 25.04.2018
(51) Int. Cl.: H05K 7/14, H05K 7/20, H05K 1/02

(54) **BACKPLANE UND VERFAHREN ZU DEREN HERSTELLUNG**

(71) Anmelder: Siemens Aktiengesellschaft, 80333 München (DE)
(72) Erfinder: SCHIFFEL, Andre, 09474 Crottendorf (DE); SERTL, Daniel, 95506 Kastl (DE)

(57) **Zusammenfassung**

Die Erfindung betrifft eine Backplane (1) zum elektrischen Verbinden elektrischer Bauelemente und ein Verfahren zu deren Herstellung. Die Backplane (1) umfasst eine Trägerplatte (3), Leiterbahnen (5), die jeweils auf und/oder in der Trägerplatte (3) verlaufen, und wenigstens ein an einer Leiterbahn (5) angeordnetes Kühlelement (7, 17) zur Kühlung der Leiterbahn (5).

## Beschreibung

Die Erfindung betrifft eine Backplane zum elektrischen Verbinden elektrischer Bauelemente und ein Verfahren zur Herstellung einer derartigen Backplane. Ferner betrifft die Erfindung einen Schaltschrank.

Unter einer Backplane wird hier ein Träger für elektrische Bauelemente verstanden, der Leiterbahnen zum elektrischen Verbinden der elektrischen Bauelemente aufweist. Derartige elektrische Bauelemente sind beispielsweise Niederspannungsschaltgeräte wie Schütze, Motorschutzschalter, Motorstarter, Sanftstarter oder Relais, oder Steuerungseinheiten oder Eingabe-/Ausgabeeinheiten. In einem Schaltschrank werden elektrische Bauelemente einer technischen Vorrichtung oder Anlage angeordnet. In herkömmlichen Schaltschränken werden elektrische Bauelemente in der Regel durch Kabel elektrisch miteinander verbunden. Bei einer Vielzahl elektrischer Bauelemente entsteht dabei ein hoher Verkabelungsaufwand.

DE 10 2016 002 052 A1 offenbart einen Schaltschrank und ein Verfahren zu dessen Herstellung. Der Schaltschrank weist zumindest eine Schalttafel mit einer Grundplatte auf, auf der elektrische Schaltelemente angeordnet und miteinander elektrisch verbunden sind. Die zumindest eine Grundplatte und/oder zumindest eines der Schaltelemente wird mittels eines 3D-Druckers in einem 3D-Druckverfahren hergestellt.

Der Erfindung liegt die Aufgabe zugrunde, eine verbesserte Backplane, ein Verfahren zur Herstellung einer derartigen Backplane und einen verbesserten Schaltschrank anzugeben.

Die Aufgabe wird erfindungsgemäß durch eine Backplane mit den Merkmalen des Anspruchs 1, einen Schaltschrank mit den Merkmalen des Anspruchs 11 und ein Verfahren mit den Merkmalen des Anspruchs 12 gelöst.

Vorteilhafte Ausgestaltungen der Erfindung sind Gegenstand der Unteransprüche.

Eine erfindungsgemäße Backplane zum elektrischen Verbinden elektrischer Bauelemente umfasst eine Trägerplatte, Leiterbahnen, die jeweils auf und/oder in der Trägerplatte verlaufen, und wenigstens ein an einer Leiterbahn angeordnetes Kühlelement zur Kühlung der Leiterbahn.

Eine erfindungsgemäße Backplane weist somit neben Leiterbahnen auch wenigstens ein Kühlelement zur Kühlung einer Leiterbahn auf. Dies ist insbesondere vorteilhaft, wenn die Leiterbahnen mittels eines erfindungsgemäßen additiven Fertigungsverfahrens, beispielsweise mittels eines 3D-Drucks, gefertigt werden, da derartig gefertigte Leiterbahnen eine geringere elektrische Leitfähigkeit als herkömmliche Kupferleitungen aufweisen, wodurch es zu einer größeren Wärmeentwicklung kommt, die eine Kühlung von Leiterbahnen erforderlich machen kann, um eine Überhitzung der Leiterbahnen und der Backplane zu verhindern.

Eine Ausgestaltung der Erfindung sieht vor, dass wenigstens ein Kühlelement ein Kühlkanal zum Leiten eines Kühlfluids ist. Von dem Kühlfluid kann ein Teil der Verlustwärme aufgenommen und von einer Leiterbahn abgeleitet werden, um die Temperatur der Leiterbahn zu senken. Das Kühlfluid ist eine Kühlflüssigkeit, beispielsweise Kühlwasser, oder ein Kühlgas, beispielsweise Luft.

Weitergestaltungen der vorgenannten Ausgestaltung der Erfindung sehen vor, dass wenigstens ein Kühlkanal eine Leiterbahn wenigstens teilweise umschließt, und/oder dass wenigstens ein Kühlkanal um eine Leiterbahn herumgewunden ist, und/oder dass wenigstens ein Kühlkanal einen Hauptkanal und von dem Hauptkanal abzweigende Nebenkanäle, die beispielsweise ringartig oder fingerartig um eine Leiterbahn herum verlaufen, aufweist. Derartig ausgebildete Kühlkanäle weisen vorteilhaft große Kontaktoberflächen auf, die mit einer Leiterbahn in thermischem Kontakt stehen, und sind daher besonders zum Aufnehmen und Ableiten von Verlustwärme der Leiterbahn geeignet.

Ferner kann wenigstens ein Kühlkanal wenigstens zwei miteinander verbundene Teilkanäle aufweisen, die in einander entgegengesetzten Richtungen von dem Kühlfluid durchströmbar sind. Dadurch kann ein Kühlkreislauf um eine Leiterbahn realisiert werden.

Des Weiteren kann wenigstens ein Kühlkanal an mehreren Leiterbahnen angeordnet sein. Dadurch kann ein Kühlkanal zur Kühlung mehrerer Leiterbahnen verwendet werden. Ferner kann die Kühlkanalstruktur gegenüber vielen einzelnen Kühlkanälen für jeweils nur eine Leiterbahn vereinfacht werden.

Eine weitere Ausgestaltung der Erfindung sieht vor, dass wenigstens ein Kühlelement ein Rippenkühlkörper mit Kühlrippen ist. Dies ermöglicht das Ableiten von Verlustwärme einer Leiterbahn durch Konvektion, wobei die Kühlrippen vorteilhaft eine große Kühloberfläche zum Ableiten der Wärme realisieren.

Eine weitere Ausgestaltung der Erfindung sieht vor, dass eine Oberfläche wenigstens einer Leiterbahn wenigstens teilweise mit einer elektrisch isolierenden Isolationsschicht beschichtet ist. Dies ist insbesondere vorteilhaft, wenn an der Leiterbahn ein aus einem elektrisch leitfähigen Material gefertigtes Kühlelement angeordnet ist, um einen elektrischen Kontakt der Leiterbahn mit den Wänden des Kühlkanals zu verhindern.

Ein erfindungsgemäßer Schaltschrank weist eine erfindungsgemäße Backplane auf.

Die Verwendung einer erfindungsgemäßen Backplane in einem Schaltschrank reduziert vorteilhaft den Aufwand und die Kosten zum elektrischen Verbinden elektrischer Bauelemente in dem Schaltschrank gegenüber dem herkömmlichen Verbinden elektrischer Bauelemente durch Kabel. Die Integration von wenigstens einem Kühlelement in die Backplane hat darüber hinaus die oben bereits genannten Vorteile, Verlustwärme von Leiterbahnen abzuleiten, um eine Überhitzung der Leiterbahnen und der Backplane zu verhindern.

Bei dem erfindungsgemäßen Verfahren zur Herstellung einer erfindungsgemäßen Backplane werden die Leiterbahnen und das wenigstens eine Kühlelement mit einem additiven Fertigungsverfahren, beispielsweise mit einem 3D-Druck gefertigt. Beispielsweise werden die Leiterbahnen aus einer elektrisch leitfähigen Paste, insbesondere aus einer Kupferpaste, gedruckt. Eine Ausgestaltung des Verfahrens sieht vor, dass auch die Trägerplatte, zumindest in Bereichen der Leiterbahnen und des wenigstens einen Kühlelements, mit dem additiven Fertigungsverfahren gefertigt wird.

Unter einem 3D-Druck wird ein Verfahren verstanden, bei dem ein dreidimensionales Objekt durch computergesteuertes schichtweises Auftragen von Material hergestellt wird.

Die vorgenannte Ausgestaltung der Erfindung berücksichtigt, dass unterschiedliche Konfigurationen elektrisch zu verbindender Bauelemente auch unterschiedliche Querschnitte und Verläufe der Leiterbahnen erfordern. Beispielsweise sind für leistungsführende Leitungen dickere Leiterbahnen als für Signalleitungen erforderlich, und unterschiedliche Anordnungen der Bauelemente erfordern unterschiedliche Verläufe der Leiterbahnen. Die Fertigung der Leiterbahnen und des wenigstens einen Kühlelements mit einem additiven Fertigungsverfahren wie mit einem 3D-Druck ermöglicht, die Querschnitte und die Verläufe der Leiterbahnen und die Ausbildung des wenigstens einen Kühlelements in einfacher Weise flexibel der Konfiguration der jeweils elektrisch zu verbindenden Bauelemente anzupassen. Eine Fertigung auch der Trägerplatte zumindest in den Bereichen der Leiterbahnen und des wenigstens einen Kühlelements mit dem additiven Fertigungsverfahren ist insbesondere vorteilhaft, wenn Leiterbahnen in der Trägerplatte verlaufen, da diese Leiterbahnen und an ihnen angeordnete Kühlelemente dann zusammen mit den sie umgebenden Bereichen der Trägerplatte gefertigt werden können.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine Draufsicht auf ein erstes Ausführungsbeispiel einer Backplane im Bereich einer Leiterbahn, an der ein Kühlkanal angeordnet ist,
- FIG 2: eine erste Schnittdarstellung des ersten Ausführungsbeispiels einer Backplane,
- FIG 3: eine zweite Schnittdarstellung des ersten Ausführungsbeispiels einer Backplane,
- FIG 4: eine Schnittdarstellung eines zweiten Ausführungsbeispiels einer Backplane,
- FIG 5: eine Schnittdarstellung eines dritten Ausführungsbeispiels einer Backplane,
- FIG 6: einen helixartig um eine Leiterbahn herum verlaufenden Kühlkanal,
- FIG 7: einen Kühlkanal mit einem Hauptkanal und mehreren Nebenkanälen, die ring- oder fingerartig um eine Leiterbahn herum verlaufen,
- FIG 8: eine Schnittdarstellung eines vierten Ausführungsbeispiels einer Backplane,
- FIG 9: eine perspektivische Darstellung eines Schaltschranks.

Einander entsprechende Teile sind in den Figuren mit denselben Bezugszeichen versehen.

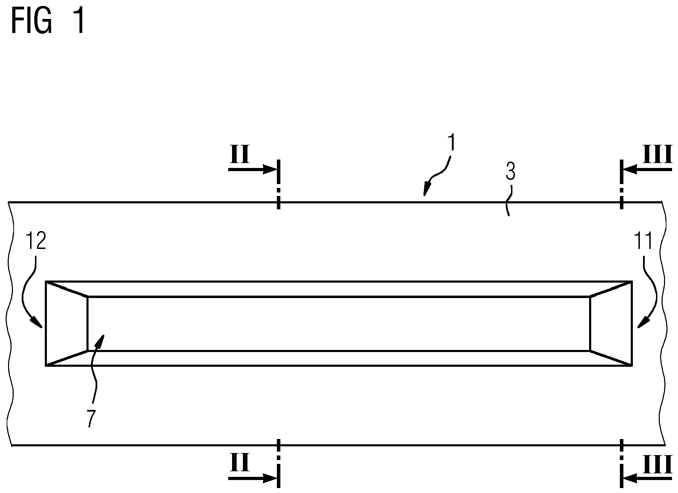

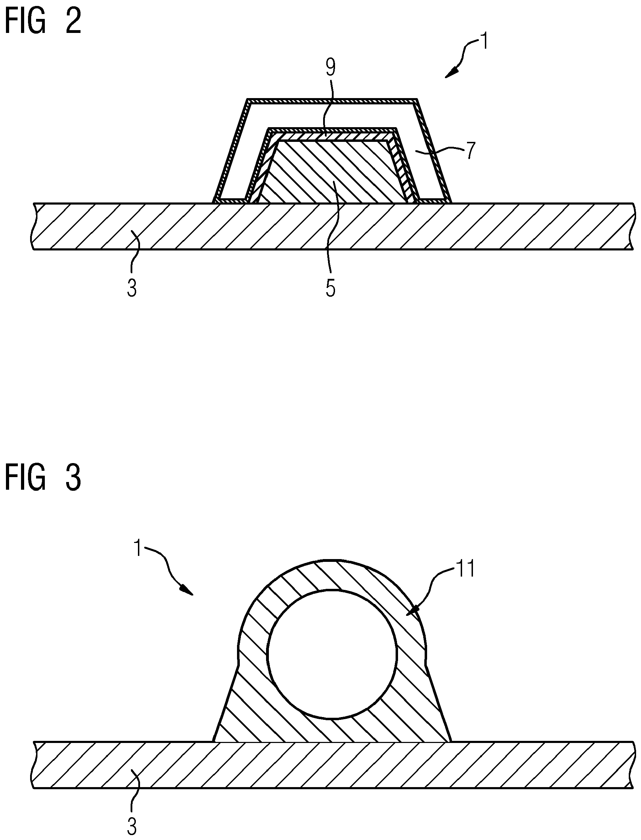

Die Figuren 1 bis 3 zeigen ein erstes Ausführungsbeispiel einer Backplane 1. Die Backplane 1 weist eine Trägerplatte 3 und eine auf der Trägerplatte 3 angeordnete Leiterbahn 5 auf, an der ein Kühlkanal 7 angeordnet ist. Figur 1 zeigt eine Draufsicht auf die Backplane 1 im Bereich der Leiterbahn 5 und die Figuren 2 und 3 zeigen jeweils eine Schnittdarstellung der Backplane 1 mit voneinander verschiedenen Schnittebenen. Dabei zeigt Figur 2 eine Schnittdarstellung in einem mittleren Bereich der Leiterbahn 5 und Figur 3 zeigt eine Schnittdarstellung in einem Endbereich des Kühlkanals 7.

Die Leiterbahn 5 ist auf einer Oberfläche der Trägerplatte 3 angeordnet. Die nicht an der Trägerplatte 3 anliegenden Oberflächen der Leiterbahn 5 sind mit einer Isolationsschicht 9 beschichtet. Der Kühlkanal 7 umgibt die Isolationsschicht 9 und ist zum Leiten eines Kühlfluids ausgebildet, um die Leiterbahn 5 zu kühlen. Das Kühlfluid ist eine Kühlflüssigkeit, beispielsweise Kühlwasser, oder ein Kühlgas, beispielsweise Luft. Jeder Endbereich des Kühlkanals 7 weist einen Kühlfluidanschluss 11, 12 auf. Durch einen ersten Kühlfluidanschluss 11 wird Kühlfluid in den Kühlkanal 7 eingeleitet, durch den zweiten Kühlfluidanschluss 12 wird Kühlfluid aus dem Kühlkanal 7 abgeleitet.

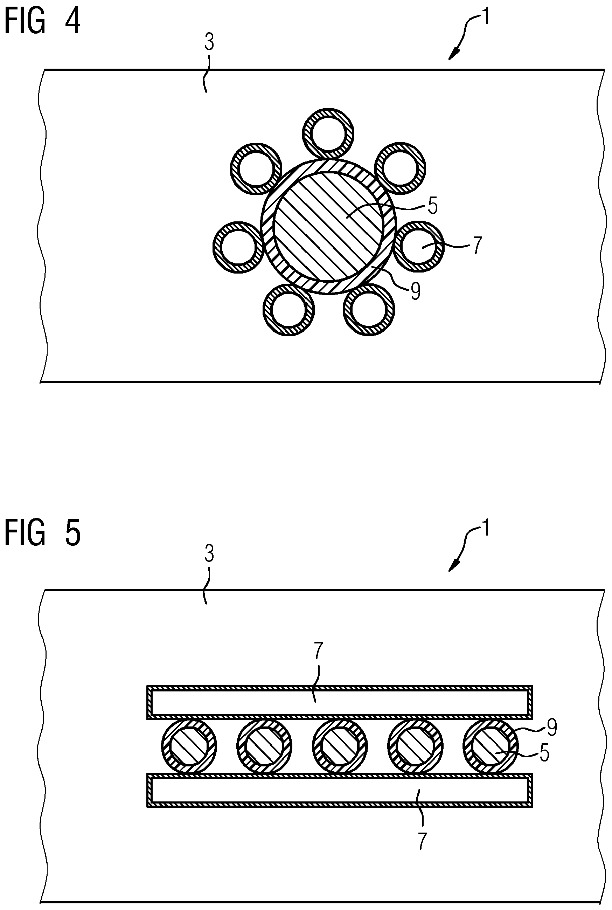

Figur 4 zeigt eine Schnittdarstellung eines zweiten Ausführungsbeispiels einer Backplane 1. Die Backplane 1 weist eine Trägerplatte 3 und eine in der Trägerplatte 3 angeordnete Leiterbahn 5 auf. Die Leiterbahn 5 ist mit einer Isolationsschicht 9 beschichtet. An der Isolationsschicht 9 sind mehrere Kühlkanäle 7 angeordnet, die parallel zu der Leiterbahn 5 in der Trägerplatte 3 verlaufen und zum Leiten eines Kühlfluids ausgebildet sind. Das Kühlfluid ist eine Kühlflüssigkeit, beispielsweise Kühlwasser, oder ein Kühlgas, beispielsweise Luft. Die Endbereiche der Kühlkanäle 7 können jeweils analog zu dem anhand der Figuren 1 bis 3 beschriebenen Ausführungsbeispiel einen Kühlfluidanschluss 11, 12 aufweisen. Dabei können auch mehrere oder alle Kühlkanäle 7 einen gemeinsamen Kühlfluidanschluss 11, 12 aufweisen. Alternativ kann nur ein Endbereich jedes Kühlkanals 7 einen Kühlfluidanschluss 11, 12 aufweisen und die anderen Endbereiche der Kühlkanäle 7 können miteinander verbunden sein, so dass die Kühlkanäle 7 einen Kühlfluidkreislauf bilden, in dem einige der Kühlkanäle 7 in einer ersten Strömungsrichtung und die anderen Kühlkanäle 7 in einer der ersten Strömungsrichtung entgegengesetzten zweiten Strömungsrichtung von dem Kühlfluid durchströmt werden.

Figur 5 zeigt eine Schnittdarstellung eines dritten Ausführungsbeispiels einer Backplane 1. Die Backplane 1 weist eine Trägerplatte 3 und mehrere in der Trägerplatte 3 angeordnete Leiterbahnen 5 auf. Jede Leiterbahn 5 ist mit einer Isolationsschicht 9 beschichtet. An den Isolationsschichten 9 ist in der Trägerplatte 3 auf zwei sich gegenüberliegenden Seiten der Leiterbahnen 5 jeweils ein Kühlkanal 7 angeordnet, der sich entlang aller Leiterbahnen 5 erstreckt und zum Leiten eines Kühlfluids ausgebildet ist. Das Kühlfluid ist eine Kühlflüssigkeit, beispielsweise Kühlwasser, oder ein Kühlgas, beispielsweise Luft. Die Endbereiche der Kühlkanäle 7 können analog zu dem anhand der Figuren 1 bis 3 beschriebenen Ausführungsbeispiel jeweils einen Kühlfluidanschluss 11, 12 aufweisen. Alternativ kann nur ein Endbereich jedes Kühlkanals 7 einen Kühlfluidanschluss 11, 12 aufweisen und die anderen beiden Endbereiche der Kühlkanäle 7 können miteinander verbunden sein, so dass die Kühlkanäle 7 einen Kühlfluidkreislauf bilden, in dem ein Kühlkanal 7 in einer ersten Strömungsrichtung und der andere Kühlkanal 7 in einer der ersten Strömungsrichtung entgegengesetzten zweiten Strömungsrichtung von dem Kühlfluid durchströmt wird.

Bei den in den Figuren 1 bis 5 gezeigten Ausführungsbeispielen sind die Leiterbahnen 5 jeweils aus einem elektrisch leitfähigen Material, beispielsweise aus Kupfer, gefertigt. Die Isolationsschichten 9 sind jeweils aus einem elektrisch isolierenden Material, beispielsweise aus einem Isolierlack, gefertigt und isolieren die Leiterbahnen 5 gegenüber den Wänden der Kühlkanale 7. Die Wände der Kühlkanale 7 sind aus einem elektrisch leitfähigen Material, beispielsweise aus einem metallischen Material, gefertigt. In alternativen Ausführungsbeispielen können die Wände der Kühlkanale 7 jedoch aus einem elektrisch isolierenden Material gefertigt sein; in diesen Fällen können die Isolationsschichten 9 zwischen den Leiterbahnen 5 und den Wänden der Kühlkanäle 7 entfallen.

Bei den in den Figuren 4 und 5 gezeigten Ausführungsbeispielen können die Wände der Kühlkanäle 7 aus einem anderen Werkstoff als die Trägerplatte 3 gefertigt sein. Alternativ können die Kühlkanäle 7 als Aussparungen in der Trägerplatte 3 ausgebildet sein.

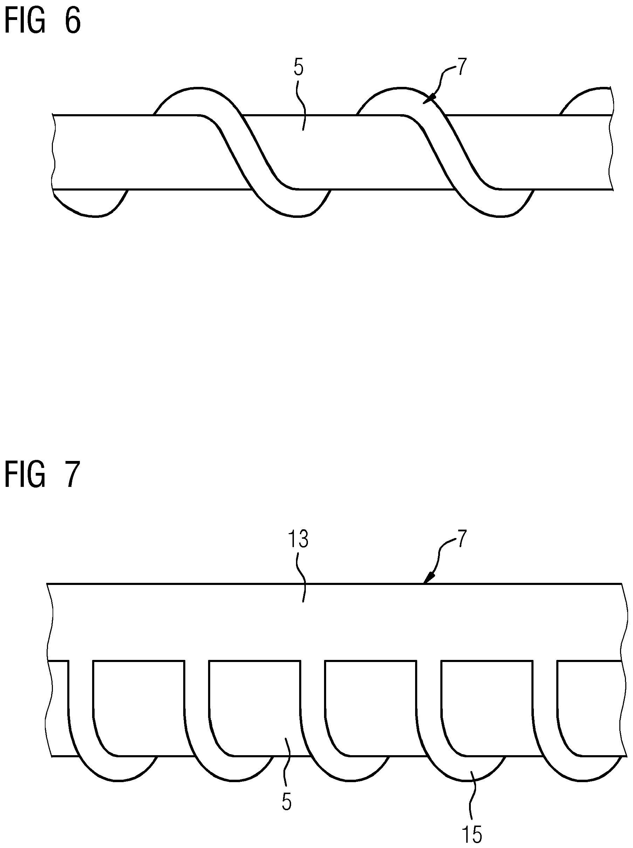

Die Figuren 6 und 7 zeigen weitere Ausführungsbeispiele jeweils einer Leiterbahn 5, an der jeweils ein Kühlkanal 7 angeordnet ist. Figur 6 zeigt einen Kühlkanal 7, der helixartig um eine Leiterbahn 5 herum verläuft. Figur 7 zeigt einen Kühlkanal 7 mit einem Hauptkanal 13, der entlang einer Leiterbahn 5 verläuft, und mehreren von dem Hauptkanal 13 abzweigenden Nebenkanälen 15, die jeweils ring- oder fingerartig um die Leiterbahn 5 herum verlaufen. Die in den Figuren 6 und 7 gezeigten Leiterbahnen 5 und Kühlkanäle 7 sind analog zu den in den Figuren 1 bis 5 gezeigten Ausführungsbeispielen jeweils auf oder in einer Trägerplatte 3 einer Backplane 1 angeordnet. Wie in diesen Ausführungsbeispielen kann die Leiterbahn 5 jeweils mit einer Isolationsschicht 9 beschichtet sind.

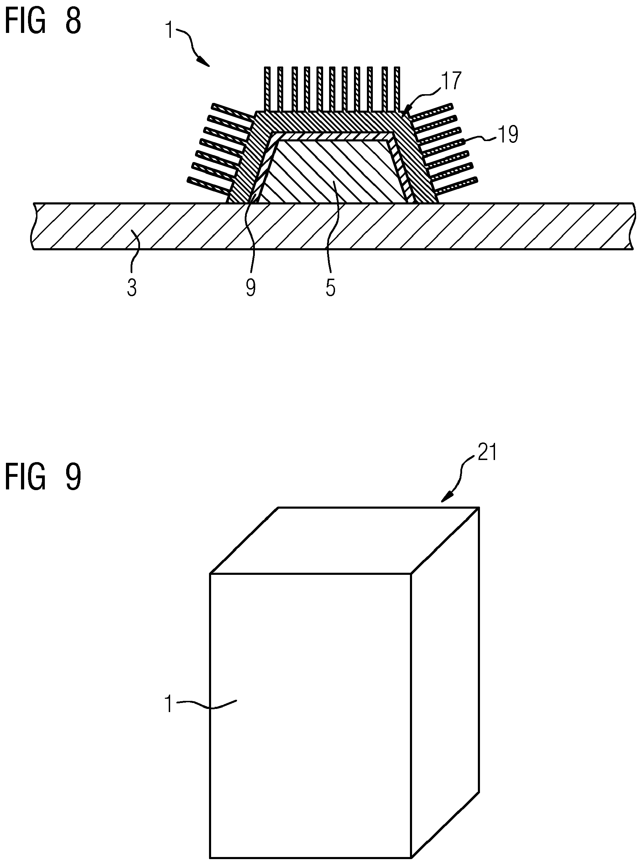

Figur 8 zeigt analog zu Figur 2 eine Schnittdarstellung eines vierten Ausführungsbeispiels einer Backplane 1. Wie das in den Figuren 1 bis 3 gezeigte Ausführungsbeispiel weist die Backplane 1 eine Trägerplatte 3 und eine auf einer Oberfläche der Trägerplatte 3 angeordnete Leiterbahn 5 auf. Die nicht an der Trägerplatte 3 anliegenden Oberflächen der Leiterbahn 5 sind mit einer Isolationsschicht 9 beschichtet. An der Isolationsschicht 9 ist ein Rippenkühlkörper 17 mit nach außen abstehenden Kühlrippen 19 zur Kühlung der Leiterbahn 5 durch Konvektion oder durch eine, beispielsweise durch einen Lüfter, erzeugte Luftströmung angeordnet. Die Leiterbahn 5 ist aus einem elektrisch leitfähigen Material, beispielsweise aus Kupfer, gefertigt. Die Isolationsschicht 9 ist aus einem elektrisch isolierenden Material, beispielsweise aus einem Isolierlack, gefertigt. Der Rippenkühlkörper 17 ist aus einem elektrisch leitfähigen Material, beispielsweise aus einem metallischen Material, gefertigt und wird durch die Isolationsschicht 9 von der Leiterbahn 5 elektrisch isoliert.

Bei allen anhand der Figuren 1 bis 8 beschriebenen Ausführungsbeispielen werden die Leiterbahnen 5, die Isolationsschichten 9 sowie die Kühlkanäle 7 beziehungsweise der Rippenkühlkörper 17 mit einem additiven Fertigungsverfahren, beispielsweise mit einem 3D-Druck, gefertigt. Insbesondere bei den in den Figuren 4 und 5 gezeigten Ausführungsbeispielen wird auch die Trägerplatte 3 zumindest in den Bereichen der Leiterbahnen 5 und Kühlkanäle 7 mit dem additiven Fertigungsverfahren gefertigt.

Figur 9 zeigt eine perspektivische Darstellung eines Schaltschranks 21. Der Schaltschrank 21 weist eine wie in einem der oben beschriebenen Ausführungsbeispiele ausgebildete Backplane 1 auf, die eine Rückwand des Schaltschranks 21 bildet.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Backplane (1) zum elektrischen Verbinden elektrischer Bauelemente, die Backplane (1) umfassend
- eine Trägerplatte (3),
- Leiterbahnen (5), die jeweils auf und/oder in der Trägerplatte (3) verlaufen, und
- wenigstens ein an einer Leiterbahn (5) angeordnetes Kühlelement (7, 17) zur Kühlung der Leiterbahn (5).

2. Backplane (1) nach Anspruch 1,
**dadurch gekennzeichnet, dass** wenigstens ein Kühlelement (7, 17) ein Kühlkanal (7) zum Leiten eines Kühlfluids ist.

3. Backplane (1) nach Anspruch 2,
**dadurch gekennzeichnet, dass** wenigstens ein Kühlkanal (7) eine Leiterbahn (5) wenigstens teilweise umschließt.

4. Backplane (1) nach Anspruch 2 oder 3,
**dadurch gekennzeichnet, dass** wenigstens ein Kühlkanal (7) um eine Leiterbahn (5) herumgewunden ist.

5. Backplane (1) nach einem der Ansprüche 2 bis 4,
**dadurch gekennzeichnet, dass** wenigstens ein Kühlkanal (7) einen Hauptkanal (13) und von dem Hauptkanal (13) abzweigende Nebenkanäle (15) aufweist.

6. Backplane (1) nach Anspruch 5,
**dadurch gekennzeichnet, dass** die Nebenkanäle (15) ringartig oder fingerartig um eine Leiterbahn (5) herum verlaufen.

7. Backplane (1) nach einem der Ansprüche 2 bis 6,
**dadurch gekennzeichnet, dass** wenigstens ein Kühlkanal (7) wenigstens zwei miteinander verbundene Teilkanäle aufweist, die in einander entgegengesetzten Richtungen von dem Kühlfluid durchströmbar sind.

8. Backplane (1) nach einem der Ansprüche 2 bis 7,
**dadurch gekennzeichnet, dass** wenigstens ein Kühlkanal (7) an mehreren Leiterbahnen (5) angeordnet ist.

9. Backplane (1) nach einem der vorhergehenden Ansprüche,
**dadurch gekennzeichnet, dass** wenigstens ein Kühlelement (7, 17) ein Rippenkühlkörper (17) mit Kühlrippen (19) ist.

10. Backplane (1) nach einem der vorhergehenden Ansprüche,
**dadurch gekennzeichnet, dass** eine Oberfläche wenigstens einer Leiterbahn (5) wenigstens teilweise mit einer elektrisch isolierenden Isolationsschicht (9) beschichtet ist.

11. Schaltschrank (21) mit einer gemäß einem der vorhergehenden Ansprüche ausgebildeten Backplane (1).

12. Verfahren zur Herstellung einer gemäß einem der Ansprüche 1 bis 10 ausgebildeten Backplane (1), wobei die Leiterbahnen (5) und das wenigstens eine Kühlelement (7, 17) mit einem additiven Fertigungsverfahren gefertigt werden.

13. Verfahren nach Anspruch 12,
**dadurch gekennzeichnet, dass** das additive Fertigungsverfahren ein 3D-Druck ist.

14. Verfahren nach Anspruch 12 oder 13,
**dadurch gekennzeichnet, dass** die Trägerplatte (3) zumindest in Bereichen der Leiterbahnen (5) und des wenigstens einen Kühlelements (7, 17) mit dem additiven Fertigungsverfahren gefertigt wird.
